# EUROPEAN PATENT APPLICATION

(11) **EP 3 099 152 A1**
(43) Date of publication of application: **30.11.2016**
(21) Application number: 16169359.3
(22) Date of filing: 12.05.2016
(51) Int. Cl.: H05K 7/20

(54) **CLOSED CABINET FOR ELECTRIC DEVICE HAVING HEAT PIPE**

(30) Priority: 26.05.2015 KR 20150072890
(71) Applicant: LSIS Co., Ltd., Gyeonggi-do 14119 (KR)
(72) Inventor: RYOO, Seong-Ryoul, 14118 Gyeonggi-do (KR)
(74) Representative: Zacco Sweden AB

(57) **Abstract**

The present invention relates to a cabinet (100) for an electric device and, more particularly, a closed cabinet for electric devices which has a heat pipe capable of efficiently dissipating heat generated from internal devices, implementing compact design of the cabinet and enhancing durability of the internal devices.

The cabinet (100) includes a device accommodation space (120) providing a closed space to accommodate the electric device, a heat dissipation duct (140) provided separately from the device accommodation space to dissipate heat generated from the device accommodation space, and heat dissipation means (160) including a heat sink attached to a heating element (125) of the device accommodation space; a heat dissipation fin (166) disposed in the heat dissipation duct (140) ; a heat pipe (164) configured to transfer heat of the heat sink (162) to the heat dissipation fin (166).

## Description

### BACKGROUND

### 1. Technical Field

The present invention relates to a cabinet for electric device and, more particularly, a closed cabinet for electric devices which has a heat pipe capable of efficiently dissipating heat generated from internal devices, implementing compact design of the cabinet and enhancing durability of the internal devices.

### 2. Description of the Related Art

In general, a cabinet for electric devices includes multiple internal devices (e.g., an inverter) generating heat.

The cabinet is provided with heat dissipation means to ensure that the internal devices can operate at a proper temperature.

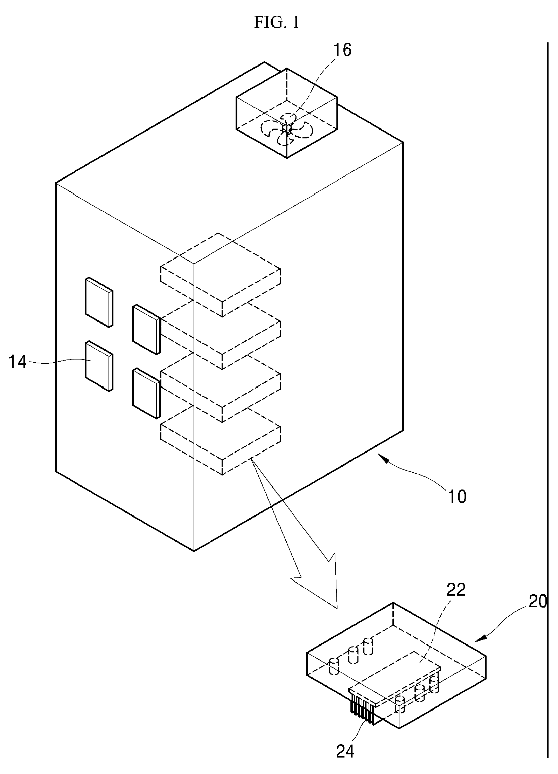

Fig. 1 is a view illustrating a medium/large-size inverter cabinet which is a kind of cabinet for electric devices.

As shown in the figure, the medium/large-size inverter cabinet 10 accommodates various electric and electronic components including an inverter.

Typically, the medium/large-size inverter cabinet 10 is provided therein with a device accommodation space configured to have multiple layers to accommodate electric devices, and electric devices 20 are accommodated in each layer in the device accommodation space.

In addition, the medium/large-size inverter cabinet 10 is structured to dissipate heat generated from the electric devices 20. The heat dissipation is implemented by cooling the devices with suctioned external air.

To perform the cooling operation, an intake port 14 is provided in one surface of the medium/large-size inverter cabinet 10, and a heat dissipation fan 16 is provided to an upper portion of the medium/large-size inverter cabinet 10.

The heat dissipation fan 16 is driven to introduce external cool air into the cabinet 10 and discharge the internal air from the cabinet 10. The cooling operation is performed in a manner that fresh air introduced from the outside cools the interior of the cabinet and is then discharged from the cabinet according to subsequent introduction of air.

In conventional cases, to effectively cool an electric device generating a high amount of heat (hereinafter, referred to as a heating element) among the electric devices provided in the medium/large-size inverter cabinet 10, a heat dissipation fin 24 is attached to one surface of the heating element 22.

With such convection-type cooling structure, however, when external air is directly introduced into the cabinet 10 at a relatively very low temperature, the temperature of the surroundings of the electric and electronic components installed therein may suddenly drop and thus dew condensation may occur. As dew condensation occurs, normal operation of the components may be disabled. To prevent the components from being disabled, a separate dehumidifier may be added or a filter is attached to the intake port to filter out moisture, salt, dust, and the like.

However, if a separate dehumidifier is added, the structure of the cabinet may become complex and large. In addition, if a filter is installed, the resistance against suction may increase due to the installed filter, and thus a fan of a higher capacity needs to be used to secure an air flow rate and velocity needed to implement the cooling. If a fan having a high capacity is used, power consumption increases. In addition, the filter needs to be regularly cleaned and replaced.

In addition, since the heat dissipation fan 16 is provided to the exterior of the cabinet 10, the heat dissipation fan 16 cannot be protected from water and foreign substances may be stuck to the heat dissipation fan. Thereby, the service life of the heat dissipation fan 16 may be shortened or malfunction may easily occur. In addition, if the heat dissipation fan 16 does not operate normally, heat dissipation efficiency of the cabinet for electric devices may be degraded, and accordingly the internal electronic components may be overrated and damaged or the service lives thereof may be shortened.

### SUMMARY

It is an aspect of the present invention to provide a closed cabinet for electric devices which is capable of effectively dissipating heat generated from the electric devices.

It is another aspect of the present invention to provide a closed cabinet for electric devices which prevents the interior of an electric device accommodation space from being contaminated by introducing external air into a separate heat dissipation duct rather than circulating the external air through the accommodation space accommodating the electronic devices.

In accordance with one aspect of the present invention, a closed cabinet for an electric device includes: a device accommodation space providing a closed space to accommodate the electric device; a heat dissipation duct provided separately from the device accommodation space to dissipate heat generated from the device accommodation space; and a heat dissipation means including: a heat sink attached to a heating element of the device accommodation space; a heat dissipation fin disposed in the heat dissipation duct; a heat pipe configured to transfer heat of the heat sink to the heat dissipation fin.

Preferably, the heat dissipation duct is vertically arranged to allow external air introduced thereinto to flow upward.

Preferably, the closed cabinet further includes a heat dissipation fan configured to accelerate flow of the air in the heat dissipation duct.

A section of the heat pipe coupled to the heat dissipation fin may be inclined upward.

Preferably, the heat dissipation fin is disposed in a vertical direction to increase an area of contact between the heat dissipation fin and the heat pipe.

The heat pipe may be disposed in a horizontal direction and provided therein with a wick to return a heat exchange fluid to the heat sink.

Herein, the heat dissipation fin may be attached to the heat pipe in an inclined manner.

Preferably, the heat dissipation means is disposed in a plurality of layers in the closed cabinet, wherein the heat dissipation fin of the heat dissipation means 160 in an upper layer has a relatively wider heat exchange area.

According to a closed cabinet for electric devices according to an embodiment of the present invention, external air does not circulate through a device accommodation space accommodating electric devices, but is introduced into a separately provided heat dissipation duct to perform the cooling operation. Thereby, the electric device accommodation space may be prevented from being contaminated by rainwater or foreign substances introduced into the space along with the external air.

In addition, according to an embodiment, the closed cabinet for electric devices employs a heat pipe. Thereby, heat generated from heating elements may be effectively dissipated.

### BRIEF DESCRIPTION OF DRAWINGS

Fig. 1 is a view illustrating configuration of a conventional cabinet for electric devices.
Fig. 2 is a view illustrating configuration of a closed cabinet for electric devices according to an embodiment of the present invention.
Fig. 3 is a perspective view illustrating a heat dissipation means according to a first embodiment of the present invention.
Fig. 4 is a side view illustrating the heat dissipation means according to the first embodiment of the present invention.
Fig. 5 is a side view illustrating a heat dissipation means according to a second embodiment of the present invention.
Fig. 6 is a side view illustrating a heat dissipation means according to a third embodiment of the present invention.
Fig. 7 is a cross-sectional view illustrating the heat dissipation means according to the third embodiment of the present invention.
Fig. 8 is a side view illustrating a heat dissipation means according to a fourth embodiment of the present invention.

### DETAILED DESCRIPTION

Terms or phrases used in this specification and appended claims should not be construed as having only meaning known to those skilled in the art or defined in dictionaries, and should be interpreted as having a meaning that is consistent with the spirit of the present invention in a sense that the inventor be properly define the terms to describe the present invention in the best mode. Hereinafter, embodiments of the present invention will be described in detail with reference to the accompanying drawings. It should be understood that the present invention is not limited to the following embodiments, and that the embodiments are provided for illustrative purposes only. The scope of the invention should be defined only by the accompanying claims and equivalents thereof.

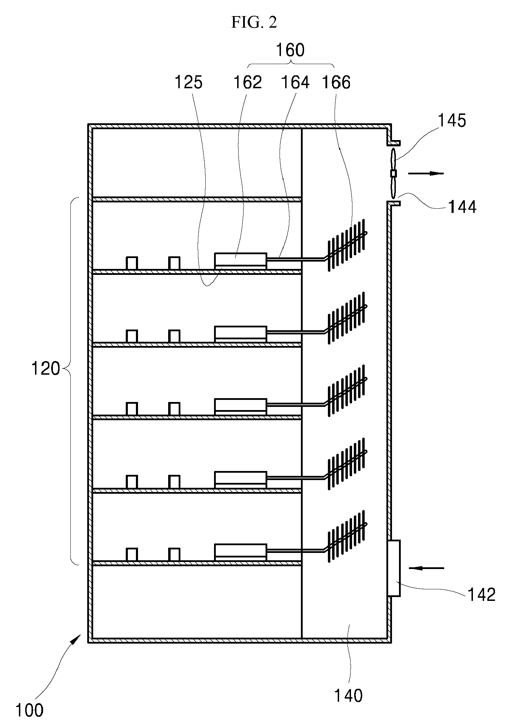

Fig. 2 is a view illustrating configuration of a closed cabinet for electric devices according to an embodiment of the present invention.

As shown in the figure, a closed cabinet 100 for electric devices according to an embodiment of the present invention includes a device accommodation space 120 for accommodating electric devices in a stacking manner, a heat dissipation duct 140 configured to dissipate heat generated from the device accommodation space 120, and a heat dissipation means 160 configured to discharge heat generated from a heating element 125 disposed in the device accommodation space 120 to the heat dissipation duct 140.

Regarding the closed cabinet 100 for electric devices, the term "closed" means that the device accommodation space 120 for accommodating electric devices is closed. In addition, the term "closed" does not mean "completely sealed", but means that the electric device cabinet of the present invention does not allow introduction of external air into the device accommodation space 120 in contrast with the conventional electric device cabinets, which allows external air to be introduced into the electric device accommodation space to circulate therein.

The cabinet 100 for electric devices is provided with the heat dissipation duct 140 separately from the device accommodation space 120 for accommodating electric devices. For the cabinet 100 for electric devices according to the present invention, external air is introduced into the heat dissipation duct 140 to dissipate heat generated from the electric devices in an air-cooling manner. Accordingly, external air need not be introduced into the device accommodation space 120, and thus foreign substances or rainwater in the external air may be prevented from contaminating the device accommodation space 120.

As shown in the figure, the heat dissipation duct 140 may be formed to have a vertical flow path. Since heated air flow upward, the heat dissipation duct 144 formed to have a vertical flow path may cause the air in the heat dissipation duct 140 to be discharged upward through natural convection.

A lower portion of the heat dissipation duct 140 may be provided with an introduction port 142, and an upper portion of the heat dissipation duct 140 may be provided with a discharge port 144. While the discharge port 144 is illustrated as being provided with a heat dissipation fan 145, the heat dissipation fan may be provided to the introduction port 142, or heat dissipation fans may be provided to both the introduction port 142 and the discharge port 144.

The heat dissipation fan provided to the introduction port 142 operates to introduce external air into the heat dissipation duct 140, and the heat dissipation fan 145 provided to the discharge port 144 operates to discharge air from the heat dissipation duct 140.

The heat dissipation means 160 provided to the cabinet 100 for electric devices includes a heat sink 162 attached to the heating element 125 accommodated in the device accommodation space 120, a heat pipe 164 configured to transfer heat from the heat sink 162 to the heat dissipation duct 140, and heat dissipation fins 166 coupled with the heat pipe 164 in the heat dissipation duct 140 to dissipate heat through contact with air.

The heat dissipation means 160 is structured such that the heat sink 162 absorbs heat of the heating element 125, the heat absorbed by the heat sink 162 is transferred to the heat dissipation fins 166 disposed in the heat dissipation duct 140 through the heat pipe 164, and the heat transferred to the heat dissipation fins 166 is transferred to external air introduced into the heat dissipation duct 140 and then discharged from the heat dissipation duct 140.

While external air introduced through the introduction port 142 rises, the external air performs heat exchange with the heat dissipation fins 166. Accordingly, the temperature of the air in the heat dissipation duct 140 increases as the air rises. As a result, the temperature of the air in the heat dissipation duct 140 differs among vertical positions. The effect of heat dissipation of the heat dissipation fins 166 is affected by the temperature of the contacting external air. Accordingly, to obtain a uniform heat dissipation effect regardless of the vertical positions, the heat exchange area of heat dissipation fins located at a higher position is preferably configured to be greater than that of heat dissipation fins located at a lower position. This structure is intended to overcome variation of the heat dissipation effect resulting from difference in temperature among vertical positions through adjustment of the heat dissipation area.

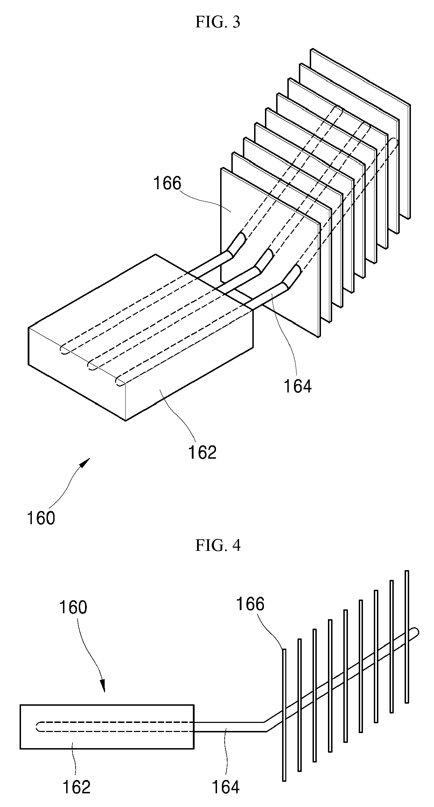

Fig. 3 is a perspective view illustrating a heat dissipation means according to a first embodiment of the present invention, and Fig. 4 is a side view illustrating the heat dissipation means according to the first embodiment of the present invention.

As shown in the figures, the heat dissipation means provided to a closed cabinet for electric devices according to an embodiment of the present invention includes the heat sink 162 attached to a heating element (e.g., a power semiconductor provided to a device such as an inverter), the heat pipe 164 having one side buried in the heat sink 162 and the other side extending into the heat dissipation duct, and the heat dissipation fins 166 attached to the heat pipe 164 in the heat dissipation duct.

According to the first embodiment, a section of the heat pipe coupled to the heat dissipation fins 166 is inclined upward.

The heat pipe 164 is configured to accommodate a heat transfer fluid in a closed body thereof. The heat transfer fluid circulates in the pipe to transfer heat through repetitive evaporation and condensation.

The evaporation occurs in a part of the pipe buried in the heat sink 162, and the condensation occurs in a part of the pipe to which the heat dissipation fins 166 are attached. Accordingly, as a section of the pipe in which condensation occurs is inclined upward, the condensed heat transfer fluid flows by gravity to a portion (the heat sink) where evaporation occurs. Thereby, the heat transfer fluid circulates and heat is transferred from the heat sink 162 to the heat dissipation fins 166.

Preferably, the heat dissipation fins 166 are disposed such that the surfaces thereof are arranged in parallel with the vertical direction. Since air is caused to flow upward in the heat dissipation duct 140 (see Fig. 2), resistance against air flow created in the heat dissipation duct may be minimized by vertically disposing the heat dissipation fins 166.

In addition, since the section of the heat pipe 164 coupled to the heat dissipation fins 166 is inclined upward, vertical disposition of the heat dissipation fins 166 produces elliptical cross sections at the portions of the heat pipe 164 to which the heat dissipation fins 166 are connected. Accordingly, the area of contact between the heat dissipation fins 166 and the heat pipe 164 increases, and thus conductivity of heat from the heat pipe 164 to the heat dissipation fins 166 may be enhanced.

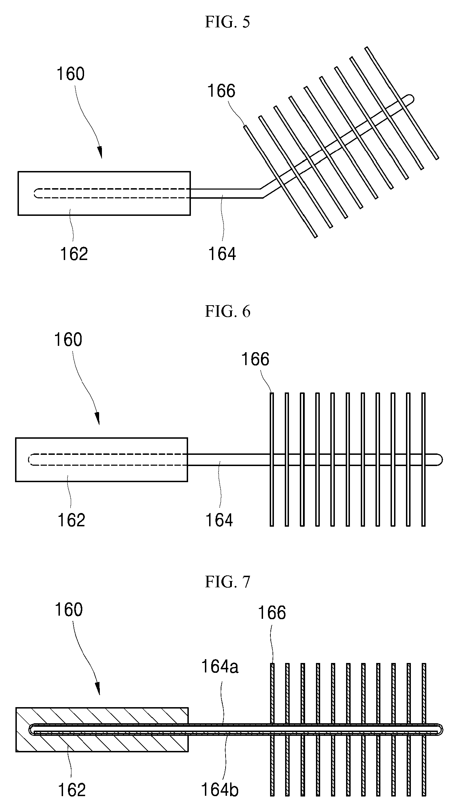

Fig. 5 is a side view illustrating a heat dissipation means according to a second embodiment of the present invention.

For the heat dissipation means according to the second embodiment, the heat dissipation fins 166 are perpendicularly coupled to the heat pipe 164.

According to the second embodiment, the number of heat dissipation fins 166 installed on the heat pipe 164 per length may be increased.

For example, if the heat pipe 164 is inclined upward at 30° in the heat dissipation duct, the length of a section of the heat pipe in which the heat dissipation fins 166 are installed is 10 cm, and the spacing between the heat dissipation fins is 2 mm, the vertical installation according to the first embodiment allows 86 heat dissipation fins 166 to be arranged in the heat dissipation duct, while perpendicular installation relative to the heat pipe according to the second embodiment allows 100 heat dissipation fins 166 to be arranged in the heat dissipation duct.

Fig. 6 is a side view illustrating a heat dissipation means according to a third embodiment of the present invention, and Fig. 7 is a cross-sectional view illustrating the heat dissipation means according to the third embodiment of the present invention.

According to the third embodiment, the heat pipe 164 is generally formed in the horizontal direction.

When a section of the heat pipe 164 where the heat dissipation fins are installed is inclined upward as in the cases of the first and second embodiments, installation of the heat dissipation means 160 may be inconvenient if the internal space of the cabinet for electric devices is limited. In other words, the height of the device accommodation space in the cabinet may not be sufficient to allow the section for installation of heat dissipation fins to be arranged therethrough. In this case, the heat dissipation means 160 needs to be pushed into the device accommodation space from one side of the heat dissipation duct, and installation of the heat dissipation means may not be easy.

According to the third environment, the heat pipe 164 is generally arranged in a horizontal direction. Thereby, the height of the section thereof for installation of the heat dissipation fins is reduced.

When the heat pipe 164 is arranged in the horizontal direction, a wick 164b to return the heat exchange fluid to the heat sink 162 is preferably provided in the heat pipe 164 as shown in Fig. 7.

The heat pipe 164 according to the third environment is charged with a heat transfer fluid in the closed pipe body 164a thereof, and is provided with the wick 164b having a capillary structure enabling circulation of the heat transfer fluid.

When the heat sink 162 is heated, the wick 164b in the heat pipe 164 connected to the heat sink 162 is dried according to evaporation of the heat transfer fluid, and the wick 164b in the heat pipe 164 connected to the heat dissipation fins 166 suctions condensed heat transfer fluid. In addition, the heat transfer fluid returns from a part of the wick 164b on the side of the heat dissipation fins 166 to a part of the wick 164b on the side of the heat sink 162 according to a capillary phenomenon. Thereby, the heat transfer fluid may circulate, and heat of the heat sink 162 may be transferred to the heat dissipation fins 166.

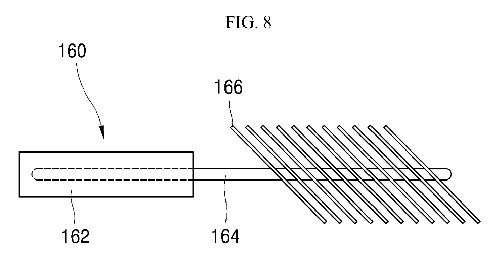

Fig. 8 is a side view illustrating a heat dissipation means according to a fourth embodiment of the present invention.

According to the fourth embodiment, the heat dissipation fins 166 are arranged inclined with respect to the heat pipe 164 to reduce the height of the section in which the heat dissipation fins 166 are installed.

As the heat dissipation fins 166 are connected to the heat pipe 164 in a manner that the heat dissipation fins 166 are inclined with respect to the heat pipe 164, the surfaces of contact between the heat dissipation fins 166 and the heat pipe 164 have an elliptical shape and thus the contact area thereof may increase, thereby improving heat transfer efficiency as described above in the first embodiment.

In addition, as the heat dissipation fins 166 are arranged inclined with respect to the heat pipe 164, the overall height of the heat dissipation means 160 may be reduced. Thereby, even if the internal space of the cabinet for electric devices is limited, the heat dissipation means 160 may be easily installed.

## Claims

1. A closed cabinet (100) for an electric device including a device accommodation space (120) configured to provide a closed space to accommodate the electric device and a heat dissipation duct (140) provided separately from the device accommodation space (120) to dissipate heat generated from the device accommodation space (120), the closed cabinet comprising:
a heat dissipation means (160) comprising:
a heat sink (162) attached to a heating element (125) of the device accommodation space (120);
a heat dissipation fin (166) disposed in the heat dissipation duct (140); and
a heat pipe (164) configured to transfer heat of the heat sink (162) to the heat dissipation fin (166).

2. The closed cabinet according to claim 1, wherein the heat dissipation duct (140) is vertically arranged to allow external air introduced therein to flow upward.

3. The closed cabinet according to claim 1 or 2, further comprising:
a heat dissipation fan (145) configured to accelerate flow of the air in the heat dissipation duct (140).

4. The closed cabinet according to any one of claims 1 to 3, wherein a section of the heat pipe (164) coupled to the heat dissipation fin (166) is inclined upward.

5. The closed cabinet according to claim 4, wherein the heat dissipation fin (166) is disposed in a vertical direction to increase an area of contact between the heat dissipation fin (166) and the heat pipe (164).

6. The closed cabinet according to any one of claims 1 to 3, wherein the heat pipe (164) is disposed in a horizontal direction and provided therein with a wick (164b) to return a heat exchange fluid to the heat sink (162).

7. The closed cabinet according to claim 6, wherein the heat dissipation fin (166) is attached to the heat pipe (164) in an inclined manner

8. The closed cabinet according to any one of claims 1 to 7, wherein the heat dissipation means (160) is disposed in a plurality of layers in the closed cabinet,
wherein the heat dissipation fin (166) of the heat dissipation means (160) in an upper layer has a relatively wider heat exchange area.
